# EUROPEAN PATENT APPLICATION

(11) **EP 2 096 678 A1**
(43) Date of publication of application: **02.09.2009**
(21) Application number: 07850921.3
(22) Date of filing: 19.12.2007
(51) Int. Cl.: H01L 29/786, H01L 21/336

(54) **SEMICONDUCTOR DEVICE AND METHOD FOR MANUFACTURING SEMICONDUCTOR DEVICE**

(30) Priority: 21.12.2006 JP 2006344404
(71) Applicant: National University Corporation Tohoku Unversity, Sendai-shi, Miyagi 980-8577 (JP); Zeon Corporation, Tokyo 100-8246 (JP); Ube Nitto Kasei Co., Ltd., Tokyo 103-0004 (JP); Ube Industries, Ltd., Ube-shi Yamaguchi 755-8633 (JP)
(72) Inventor: OHMI, Tadahiro, Sendai-shi Miyagi 980-8577 (JP); SUGITANI, Koichi, Tokyo 100-8246 (JP); KOIKE, Tadashi, Gifu-shi Gifu 500-8386 (JP); BAMBA, Akinori, Gifu-shi Gifu 500-8386 (JP); KOBAYASHI, Akihiro, Gifu-shi Gifu 500-8386 (JP); WATANUKI, Kohei, Tokyo 105-8449 (JP)
(74) Representative: Vossius & Partner
(86) International application number: PCT/JP2007/074451
(87) International publication number: WO 2008/075727

(57) **Abstract**

A thin-film transistor (TFT) has a gate insulating film excellent in transparency and flatness. The gate insulating film is formed by a transparent insulating film (131) which is composed of an oxide represented by RₓMO_{y} and which is arranged between a gate electrode and a semiconductor layer. The transparent insulating film (131) is made of a coating agent which is composed of one mixed liquid obtained by dissolving or dispersing a condensate, which is obtained by subjecting a compound represented by RₓMXₘ₋ₓ (where R represents a non-hydrolyzable substituent, M represents Si, Ti, Al, Zr, Zn, Sn or In, X represents a hydrolyzable substituent, x represents an integer of 0-3, and m represents the valence of M) to a hydrolysis-condensation reaction, in an organic solvent, water or their mixed solvent, or alternatively a coating agent which is obtained by mixing two or more of such mixed liquids.

## Description

### Technical Field

This invention relates to a semiconductor device, particularly a thin-film transistor (TFT), and further relates to a manufacturing method thereof.

### Background Art

Generally, a display device, such as a liquid crystal display device, an organic EL device, or an inorganic EL device is fabricated by forming films and patterning the films into conductive patterns such as a wiring pattern and an electrode pattern in sequence on a transparent substrate having a flat main surface. Then, by forming and patterning an electrode film, various films necessary for elements that constitute the display device, and so on in sequence, the display device is manufactured.

In recent years, there is a growing demand for an increase in size with respect to this type of display device. In order to form a large-size display device, it is necessary to form more display elements on a substrate with high accuracy and to electrically connect these elements to a wiring pattern. In this case, insulating films, TFT (thin-film transistor) elements, light emitting elements, and so on are formed, in addition to the wiring pattern, on the substrate in a multilayered state. As a result, level differences are normally formed on the substrate in a stepwise fashion and the wiring pattern is arranged across these level differences. Further, when increasing the size of the display device, since the wiring pattern itself becomes longer, it is necessary to reduce the resistance of the wiring pattern.

As a technique for solving the level differences of the wiring pattern and reducing the resistance thereof, Patent Document 1 and Patent Document 2 each disclose that, in order to form wiring for a flat panel display such as a liquid crystal display, a wiring pattern is formed on the surface of a transparent substrate and a transparent insulating material having a height equal to that of the wiring pattern is formed in contact with the wiring pattern. Further, in Patent Document 2, there is disclosed a method of more flattening the wiring by heat press or CMP.

Patent Document 3 proposes forming a gate electrode comprising an adhesive underlayer, a catalyst layer, a conductive metal layer, and a diffusion suppressing layer formed thereon. This proposal makes it possible to improve the adhesion to a glass substrate and the flatness of the gate electrode.

- Patent Document 1:: WO 2004/110117
- Patent Document 2:: JP-A-2005-210081
- Patent Document 3:: Japanese Patent Application No. 2005-173050

### Disclosure of the Invention

### Problem to be Solved by the Invention

Patent Document 1 discloses that the characteristics of a display device can be improved by embedding wiring in a groove formed by a resin pattern to provide the thick-film wiring, and further discloses techniques such as an inkjet method and a screen printing method as wiring forming methods. However, it has been found out that the disclosed methods have a problem in adhesion to the substrate. Further, it has also been found out that if the wiring is formed by a conductive ink, screen printing, or the like as described in Patent Document 1, the surface of the wiring becomes rough so that the flatness of an insulating layer or the like formed on the wiring is degraded. When the wiring formed by the conductive ink or the screen printing is used as a gate electrode, there has been observed a phenomenon in which the propagation ratio of carriers passing through a channel is degraded due to the roughness of the wiring surface.
This makes the high-speed operation difficult. Further, it has also been found that, using the conductive ink, the screen printing, or the like, when the wiring is fine, it is difficult to obtain a desired shape. For example, it has been found that even if an attempt is made to form a gate electrode with a width of 20µm and a length of 50µm using such a method, an electrode material does not spread over the entire surface and thus it is practically impossible to form a desired pattern.

As a method of solving the problem of the roughness of the wiring surface, Patent Document 2 proposes a process of performing heat press treatment or CMP treatment that presses an insulating film and embedded wiring by the use of a press member. However, with an increase in size of mother glass substrates in recent years, those wiring flattening methods have become impractical particularly in the case of fifth-generation glass substrates having sizes of 1100mm × 1300mm or more. In the heat press treatment, even a slight strain of glass leads to breakage thereof, while, it is very difficult to uniformly polish the entire surface of a large-size glass substrate by the CMP, which leads to an increase in cost.

Further, there has also been observed a phenomenon in which a gap is formed between a plated layer and a surrounding resin film. This might be based on the fact that the resin expands due to high temperatures in plating treatment and then shrinks after plating formation. Such a gap results in local concentration of an electric field on a gate insulating film and brings about dielectric breakdown. As a result, a gate electrode and a channel region are shorted to each other.

Further, in order to enhance the adhesion, Patent Document 3 proposes a manufacturing method which comprises at least a process of decorating or modifying the surface of an insulating substrate, a process of forming a resin film on the insulating substrate, a process of patterning the resin film to form a recess for receiving therein an electrode or wiring, a process of applying a catalyst to the recess, a process of heat-curing the resin film, and a process of forming a conductive material in the recess by a plating method. A conductive metal layer, for example, a Cu layer, of a gate electrode or the like is formed by an electroless plating method and, thereon, as a Cu-diffusion suppressing layer, a W layer is formed by a selective CVD method or a Ni layer is formed by the electroless plating method, thereby forming the gate electrode.

According to this method, the adhesion of the gate electrode to the substrate is improved and, further, even in the case of a gate electrode with a width of 20µm and a length of 50µm, it is possible to form a desired pattern regardless of the size. However, it has been found that, even with this method, the surface of the gate electrode is rough so that the flatness of a gate insulating layer formed on the gate electrode is poor. For example, it has been found that the flatness of the surface of the Cu layer formed by electroless plating reaches even 17.74nm in Ra and the flatness of the surface of the Ni layer formed thereon also reaches as high as 8.58nm in Ra, and because of this surface roughness, the surface of silicon nitride formed as a gate insulating film by CVD, i.e. the interface with a channel region of a semiconductor layer, is also rough and thus the carrier mobility is degraded due to surface scattering.

It is an object of this invention to provide a thin-film transistor (TFT) excellent in flatness of a gate insulating film and a manufacturing method thereof.

It is another object of this invention to provide a thin-film transistor having a gate insulating film with excellent interface flatness and high transparency and a manufacturing method thereof.

It is still another object of this invention to provide a coating agent that can form a gate insulating film excellent in transparency and flatness.

### Means for Solving the Problem

Hereinbelow, configurations of this invention will be enumerated.

According to a first aspect of this invention, there is provided a semiconductor device which comprises a transparent base, a transparent insulator film A provided on a main surface of said transparent base and formed with a groove reaching said main surface, a gate electrode formed in said groove so that a surface of said gate electrode and a surface of said transparent insulator film A are substantially flush with each other, and a semiconductor layer provided over said gate electrode through a gate insulating film, wherein said gate insulating film comprises at least two layers and wherein at least one layer of said gate insulating film is a transparent insulator film B which has a main skeleton of repeating MO units and which has a composition comprising one kind or two or more kinds of oxides each represented by RₓMO_{y} [where R represents a non-hydrolyzable substituent, M represents one element selected from a group consisting of Si, Ti, Al, Zr, Zn, Sn, and In, x represents an integer of 0 to 3, and y satisfies the following formula: (m-x)/2<y<m-x-0.5 (m represents a valence of M)].

According to a second aspect of this invention, there is provided a semiconductor device which comprises a transparent base, a transparent insulator film A provided on a main surface of said transparent base and formed with a groove reaching said main surface, a gate electrode formed in said groove so that a surface of said gate electrode and a surface of said transparent insulator film A are substantially flush with each other, and a semiconductor layer provided over said gate electrode through a gate insulating film, wherein said gate insulating film comprises at least two layers and wherein at least one layer of said gate insulating film is a transparent insulator film B formed by heating in a temperature range of 150 to 300°C and having a turbidity (Hz) of 3% or less and a transmittance (Tt) of 80% or more.

According to a third aspect of this invention, there is provided a semiconductor device according to the first or the second aspect, wherein said transparent insulator film B is a transparent insulator coating film formed by coating a coating solution.

According to a fourth aspect of this invention, there is provided a semiconductor device according to any of the first through the third aspects, wherein said transparent insulator film B has a surface roughness (Ra) of 5nm or less.

According to a fifth aspect of this invention, there is provided a semiconductor device according to any of the first through the fourth aspects, wherein said transparent insulator film B satisfies a relationship of 280>d/ε where a thickness thereof is given by d(Å) and a relative permittivity thereof is given by ε.

According to a sixth aspect of this invention, there is provided a coating agent for forming the transparent insulator film B according to any of the third to the fifth aspects, which further comprises one kind or a mixture of two or more kinds of mixed solutions each obtained by dissolving or dispersing, in an organic solvent, water, or a mixed solvent thereof, a condensate obtained by a hydrafysis-candensation reaction of a compound represented by RₓMXₘ₋ₓ (where R represents a non-hydrolyzable substituent, M represents one element selected from a group consisting of Si, Ti, Al, Zr, Zn, Sn, and in, X represents a hydrolyzable substituent, x represents an integer of 0 to 3, and m represents a valence of M).

According to a seventh aspect of this invention, there is provided a coating agent for forming the transparent insulator film B according to any of the third to the fitth aspects, which is formed by dissolving or dispersing, in an organic solvent, water, or a mixed solvent thereof, a condensate obtained by a hydrolysis-condensation reaction of one kind or two or more kinds of compounds each represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents a valence of M).

According to an eighth aspect of this invention, there is provided a coating agent according to the sixth or the seventh aspect, wherein said hydrolyzable substituent X is an alkoxyl group.

According to a ninth aspect of this invention, there is provided a semiconductor device according to any of the first through the fifth aspects, wherein said gate insulating film further comprises an insulator film C formed by CVD and having a relative permittivity of 4 or more.

According to a tenth aspect of this invention, there is provided a semiconductor device according to the ninth aspect, wherein said insulator film C is transparent and extends over said transparent insulator film B.

According to an eleventh aspect of this invention, there is provided a semiconductor device manufacturing method comprising forming a transparent insulator film A on a surface of a transparent base; forming a groove, reaching said transparent base, by selectively removing part of said transparent insulator film A; forming, in said groove, a gate electrode reaching the surface of said transparent base; coating, on a surface of said transparent insulator film A including a surface of said gate electrode, either a coating agent comprising one kind or a mixture of two or more kinds of mixed solutions each obtained by dissolving or dispersing, in an organic solvent, water, or a mixed solvent thereof, a condensate obtained by a hydrolysis-condensation reaction of a compound represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents a valence of M) or a coating agent which is obtained by dissolving or dispersing, in an organic solvent, water, or a mixed solvent thereof, a condensate obtained by a hydrolysis-condensation reaction of one kind or two or more kinds of compounds each represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents a valence of M); heating a coating film obtained in said coating; and forming a semiconductor film over a transparent insulator film B thus obtained.

According to a twelfth aspect of this invention, there is provided a semiconductor device manufacturing method according to the eleventh aspect, wherein said hydrolyzable substituent X is an alkoxyl group.

According to a thirteenth aspect of this invention, there is provided a semiconductor device manufacturing method according to the eleventh or the twelfth aspect, further comprising, between said coating film heating and said semiconductor film forming, forming a transparent insulator film C having a relative permittivity of 4 or more by CVD so as to cover said transparent insulator film B.

### Effect of the Invention

According to this invention, an insulator coating film is provided on a gate electrode having a rough surface so as to have a surface flatness of 5nm or less in Ra, thereby forming a gate insulating film having high transparency and optically and electrically excellent properties, so that it is possible to provide the gate insulating film that prevents interface scattering of carriers because of its interface with a channel region being flat and thus achieves high carrier mobility and that maintains excellent optical and electrical properties at a portion other than at the gate electrode. Further, according to this invention, there is obtained a coating agent excellent in transparency and flatness and suitable for forming the gate insulating film.

### Brief Description of the Drawings

Fig. 1 is a sectional view showing one example of the structure of a thin-film transistor according to this invention.
Fig. 2 is a sectional view showing, in an enlarged manner, one example of the structure of a gate electrode portion of the thin-film transistor according to this invention.
Fig. 3 is a sectional view for explaining a process of a method of manufacturing a thin-film transistor according to an Example of this invention.
Fig. 4 is a sectional view for explaining a process performed subsequent to the process shown in Fig. 3.
Fig. 5 is a sectional view for explaining a process performed subsequent to the process shown in Fig. 4.
Fig. 6 is a sectional view for explaining a process performed subsequent to the process shown in Fig. 5.
Fig. 7 is a sectional view for explaining a process performed subsequent to the process shown in Fig. 6.

### Description of Symbols

- 10: glass substrate
- 11: transparent insulator film A
- 12: gate electrode
- 121: adhesive underlayer
- 122: catalyst layer
- 123: conductive metal layer
- 124: conductive-metal diffusion suppressing layer
- 13: gate insulating film
- 131: transparent insulator film B
- 132: insulator film C
- 14: semiconductor layer
- 141: amorphous silicon film
- 142: n+ amorphous silicon film
- 15: source electrode
- 16: drain electrode

### Best Mode for Carrying Out the Invention

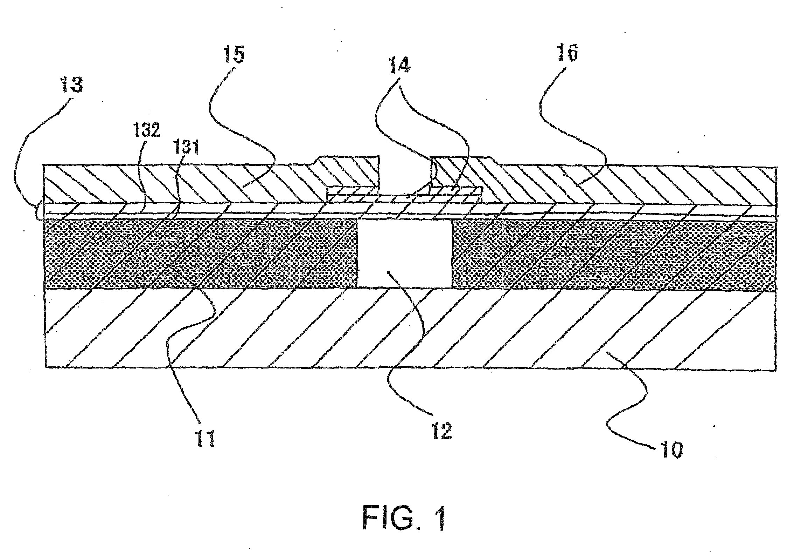

An embodiment of this invention will be described with reference to the figures. Fig. 1 is a sectional view showing one example of the structure of a thin-film transistor (TFT) of this invention. The illustrated thin-film transistor has a transparent resin film 11 (corresponding to a transparent insulator film A) of a transparent photosensitive resin formed on a glass substrate (insulating substrate) 10, a gate electrode 12 formed in the transparent resin film 11 so as to reach the glass substrate 10 and extend to approximately the same height as the transparent resin film 11, a gate insulating film 13 composed of an insulator coating film 131 (corresponding to a transparent insulator film B) formed on the transparent resin film 11 and the gate electrode 12 so as to lie over them and a CVD dielectric film 132 (corresponding to an insulator film C) formed on the insulator coating film 131, a semiconductor layer 14 formed over the gate electrode 12 through the gate insulating film 13, and a source electrode 15 and a drain electrode 16 each connected to the semiconductor layer 14.

As described in this embodiment, the gate insulating film 13 is preferably formed by the two layers, i.e. the transparent insulator film B131 and the insulator film C132. Further, in terms of satisfactorily exhibiting the desired effect of this invention, the transparent insulator film B131 is preferably formed on the surface of the transparent insulator film A11, including the surface of the gate electrode 12.

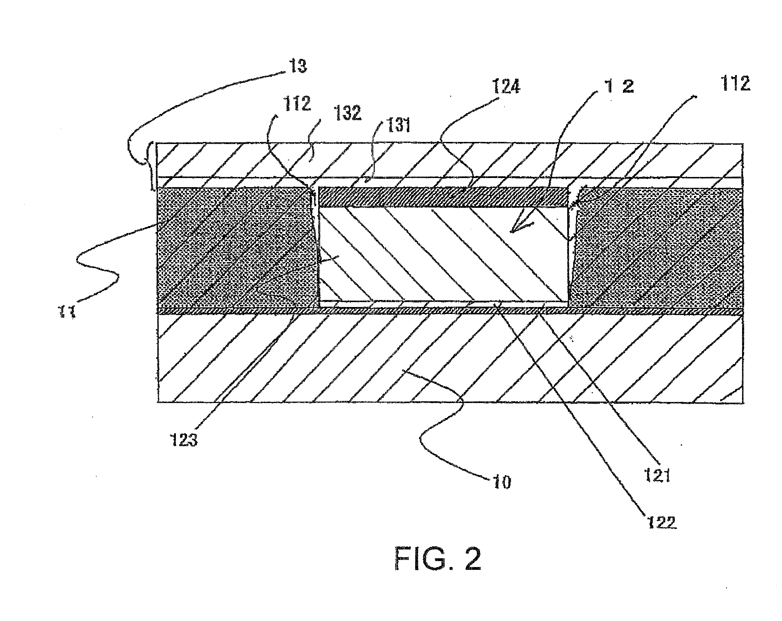

Fig. 2 is a sectional view showing, in an enlarged manner, the structure of a gate electrode portion of the thin-film transistor according to this invention. The illustrated gate electrode 12 comprises, from the glass substrate 10 side toward the semiconductor layer side (i.e. in order from the lower side of the figure), an adhesive underlayer 121, a catalyst layer 122, a conductive metal layer 123, and a conductive-metal diffusion suppressing layer 124 and is embedded in a groove formed in the flat transparent resin film 11.

As is also clear from Fig. 2, the gate electrode 12 is embedded in the groove of the transparent resin film 11 so that the surface of the gate electrode 12 and the transparent resin film 11 form substantially the same plane. Accordingly, the flatness of the upper structure of the gate electrode 12 is ensured, but there is a problem in flatness when observed microscopically.
That is, the conductive metal layer 123 is normally formed by electroless plating of Cu, wherein, however, the flatness of the surface of the conductive metal layer 123 (Cu layer) formed by electroless plating reaches even 17.74nm in Ra and the flatness of the surface of the conductive-metal diffusion suppressing layer 124 (electroless-plated Ni layer) formed thereon also reaches as high as 8.58nm in Ra.

In this invention, the insulator coating film having a thickness of 40nm or more is formed as the transparent insulator film B131 on the conductive-metal diffusion suppressing layer 124 and this film buries a gap 112 between the gate electrode 12 and the resin film 11 and provides a flat surface of 5nm or less in Ra which is not influenced by the irregularities of the surface of the gate electrode 12. As a result, it is possible to obtain the surface flatness of the silicon nitride dielectric film (insulator film C) 132 with a thickness of 150 to 160nm formed by CVD on the transparent insulator film B131 being the insulator coating film (overcoat film). Consequently, it is possible to form the thin-film transistor (TFT) without an influence of irregularities which might result from the gate electrode, in the semiconductor layer formed on the gate insulating film 13. Thus, the mobility can be considerably improved.

It should be noted that the transparent insulator film B131 being the insulator coating film (overcoat film) is formed using the following coating agent instead of conventionally known SOG (spin-on glass).

### 1. Kind of Solvent:

Use can be made of organic solvents such as alcohols such as methanol, ethanol, isopropyl alcohol, propyl alcohol, and cyclohexanol, glycols such as ethylene glycol and propylene glycol and derivatives thereof, ketones such as acetone, methyl isobutyl ketone, and cyclohexanone, and further, toluene, xylene, ethers, and aliphatic hydrocarbons, water, and the like. These may be used alone or as a mixture of two or more kinds.

### 2. Kind of Material and Ratio Range:

As the coating agent, use is made of a coating agent composed of one kind or a mixture of two or more kinds of mixed solutions each obtained by dissolving or dispersing, in the above solvent, a condensate obtained by a hydrolysis-condensation reaction of a compound represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents the valence of M), or a coating agent obtained by dissolving or dispersing, in the above solvent, a condensate obtained by a hydrolysis-condensation reaction of one kind or two or more kinds of compounds each represented by R_{X}MXₘ₋ₓ described above.

In the above compound represented by RₓMXₘ₋ₓ, the non-hydrolyzable substituent R is an alkyl group, an alkyl group having a (meth)acryloyloxy group or an epoxy group, an alkenyl group, an aryl group, or an aralkyl group. Specifically, as the non-hydrolyzable substituent, there can be cited, for example, methyl group, ethyl group, n-propyl group, isopropyl group, n-butyl group, isobutyl group, sec-butyl group, tert-butyl group, pentyl group, hexyl group, octyl group, cyclopentyl group, cyclohexyl group, y-acryloyloxypropyl group, y-methacryloyloxypropyl group, y-glycidoxypropyl group, 3,4-epoxycyclohexyl group, vinyl group, allyl group, butenyl group, hexenyl group, octenyl group, phenyl group, tolyl group, xylyl group, naphthyl group, benzyl group, phenethyl group, phenylpropyl group, naphthylmethyl group, and the like. In terms of heat resistance, adhesion, cost, flattening property, and so on, the methyl group, the ethyl group, or the phenyl group is preferable.

The hydrolyzable substituent X is a halogen atom, an alkoxyl group, hydrogen, an isocyanate group, a silazane group, a coordination substituent, or the like. Specifically, as the hydrolyzable substituent, there can be cited, for example, chlorine atom, methoxy group, ethoxy group, n-propoxy group, isopropoxy group, n-butoxy group, isobutoxy group, sec-butoxy group, tert-butoxy group, pentoxy group, hexoxy group, cyclopentoxy group, cyclohexoxy group, acetylacetonate group, and the like. In terms of ease of reaction control and cost, the methoxy group, the ethoxy group, the propoxy group, or the butoxy group is preferable. M is preferably Si, Ti, or Al and X is preferably 0 to 2.

As the above compound represented by RₓMXₘ₋ₓ, there can be cited, for example, methyltrimethoxysilane, methyltriethoxysilane, methyltripropoxysilane, methyltriisopropoxysilane, ethyltrimethoxysilane, ethyltriethoxysilane, propyltriethoxysilane, butyltrimethoxysilane, phenyltrimethoxysilane, phenyltriethoxysilane, dimethyldimethoxysilane, methylphenyldimethoxysilane, methyltrichlorosilane, ethyltrichlorosilane, dimethyldichlorosilane, tetramethoxysilane, tetraethoxysilane, tetra-n-propoxysilane, tetraisopropoxysilane, tetra-n-butoxysilane, tetraisobutoxysilane, tetra-sec-butoxysilane, tetra-tert-butoxysilane, tetrachlorosilane, and the like, and further, corresponding thereto, tetraalkoxytitanium, trialkoxytitanium, dialkoxytitanium, trimethoxyaluminum, triethoxyaluminum, tri-n-propoxyaluminum, triisopropoxyaluminum, tri-n-butoxyaluminum, triisobutoxyaluminum, tri-sec-butoxyaluminum, tri-tert-butoxyaluminum, and the like. In terms of ease of reaction, cost, adhesion, and flattening property, the methyltrimethoxysilane, the methyltriethoxysilane, the methyltripropoxysilane, the methyltriisopropoxysilane, the ethyltrimethoxysilane, the ethyltriethoxysilane, the phenyltrimethoxysilane, the dimethyldimethoxysilane, the tetramethoxysilane, the tetraethoxysilane, or the like, or the tetraalkoxytitanium corresponding thereto is preferable. Among them, it is preferable to use a mixture of condensates of the methyltrimethoxysilane and the tetraethoxysilane. The content ratio of both condensates is preferably 1/9 to 8/2 in mole ratio (former/latter).

The hydrolysis-condensation reaction of the above compound represented by RₓMXₘ₋ₓ can be carried out by, for example, using an acid or a base as a catalyst, adding water, maintaining at a temperature of 0 to 80°C in a predetermined solvent, and agitating for about 1 to 24 hours by the use of a reactor with an agitator.

The content of the above condensate in the coating agent is not particularly limited, but is normally 0.5 to 25wt%. Although the optimal value differs depending on a coating method or film thickness setting, it is preferably 1 to 10wt% in terms of time-dependent changes of the coating agent.

### 3. Other Components:

A leveling agent, a viscosity adjusting agent, or the like may be added.

The above coating agent is coated on the surface including the gate electrode 12 and the transparent insulator film A11 being the transparent resin film and then heated. As a result, the transparent insulator film B131 is formed as the insulator coating film (overcoat film) on the gate electrode 12 and the transparent insulator film A11.

In this case, the components (composition) and properties of the substance forming the transparent insulator film B131 being the insulator coating film (overcoat film) are as follows.

### (1) Component:

Repeating MO units form the main skeleton and the composition thereof is composed of one kind or a mixture of two or more kinds of oxides each represented by RₓMO_{y} [where R represents a non-hydrolyzable substituent, M represents one element selected from a group consisting of Si, Ti, Al, Zr, Zn, Sn, and In, x represents an integer of 0 to 3, and y satisfies the following formula: (m-x)/2<y<m-x-0.5 (m represents the valence of M)]. R is the same as aforementioned and preferred modes of R, M, and x are also the same as aforementioned.

### (2) Feature of Thin Film:

280>d/ε (d: thickness (Å) of the thin film, ε: relative permittivity of the thin film). Normally, the lower limit of d/ε is 40.

The surface roughness is 5nm or less in Ra.

The insulator coating film, when the above coating agent is coated and then heated at an arbitrary temperature of 150 to 300°C, exhibits Hz (turbidity)<3% and Tt (transmittance)>80% and thus has sufficient transparency as the gate insulating film 13 of the thin-film transistor.

The above relative permittivity can be measured by CVmap92 manufactured by Four Dimensions, Inc., the above surface roughness Ra can be measured by an AFM (SPA400 manufactured by Seiko Instruments, Inc.), and the above turbidity and transmittance can be measured by a turbidimeter ("NDH2000 (measurement method 2)" manufactured by Nippon Denshoku Industries Co., Ltd.).

After forming the transparent insulator film B131, the silicon nitride dielectric film is formed as the insulator film C132 on the surface of the transparent insulator film B131 by CVD.

Herein, as the thickness of the gate insulating film 13 comprising the transparent insulator film 131 as the insulator coating film and the insulator film C132 as the CVD dielectric film thereon, if it is too large, the driving capability of the transistor decreases and the gate capacitance increases to cause signal delay, and therefore, it is preferably about 350 to 360nm or less in the case of a silicon nitride film and 200nm or less in EOT (equivalent silicon dioxide thickness obtained by the product of the thickness of a film and the quotient of the permittivity of silicon dioxide divided by the average permittivity of the film).

If the thickness of the gate insulating film 13 is too small, the leakage current increases, and since a maximum voltage of 15V is applied between gate and source of a TFT in a normal LCD, the withstand voltage is preferably 15V or more, and therefore, the thickness of the gate insulating film 13 is preferably 95nm or more in EOT.

On the other hand, with respect to the thickness of the insulator coating film (i.e. the transparent insulator film B) 131 forming the gate insulating film 13, the physical thickness thereof is required to be 40nm at minimum (when the surface roughness of an underlayer is about 30nm in P-V) for obtaining a flat surface regardless of the roughness of the underlayer. The permittivity of this film is optional, but taking into account that the permittivity is about 10 at maximum, the thickness of this film is preferably set to 15nm or more in equivalent silicon dioxide thickness (EOT). In the case of the composite gate insulating film 13, the maximum thickness is preferably about 120nm or less. When calculating d/ε, the thickness of the transparent insulator film B131 is used by converting it into Å.

The thickness of the CVD dielectric film (insulator film C) 132 is preferably 80nm or more in EOT, taking into account that this film is mainly responsible for the withstand voltage. The upper limit thereof is preferably 200nm-15nm=185nm.

### Example

Next, a method of forming a thin-film transistor according to an Example of this invention described above will be described with reference to the figures.

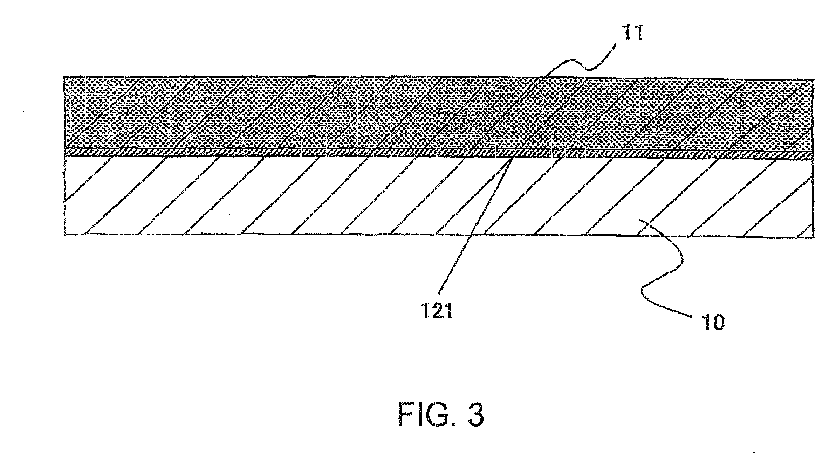

Figs. 3 to 7 are exemplary diagrams showing the method of manufacturing the thin-film transistor according to this Example in order of process. First, referring to Fig. 3, a glass substrate 10 was prepared as a substrate. This glass substrate may be a large-size substrate that can form a large-size screen of 30 inches or more. This glass substrate was treated with a 0.5vol% hydrofluoric acid aqueous solution for 10 seconds and then washed with pure water to remove, by lift-off, surface contamination.

Then, the glass substrate 10 was treated with a silane coupling agent solution in which aminopropylethoxysilane being a silane coupling agent was dissolved at a concentration of 0.1vol% in an aqueous solution whose pH was controlled at 10 by adding pure water to sodium hydroxide, i.e. immersed in the silane coupling agent solution at room temperature for 30 minutes, thereby adsorbing the silane coupling agent on the surface of the glass substrate. Thereafter, treatment was carried out on a hot plate at 110°C for 60 minutes to chemically bond the silane coupling agent to the surface of the glass substrate, thereby forming an adhesive underlayer (thickness 10m) 121. By forming the adhesive underlayer 121 in this manner, it is possible to form a structure in which amino groups are substantially arranged on the substrate surface and metal complexes are easily coordinated thereto. Since the silane coupling agent is normally transparent, even if it is formed over the entire surface of the glass substrate, it is possible to obtain the effect of this invention, and further, the silane coupling agent is preferable in terms of obtaining the adhesion between the glass substrate and a transparent photosensitive resin to be used in a subsequent process.

After forming the adhesive underlayer 121, a positive photoresist solution was coated on the surface of the adhesive underlayer by the use of a spinner and then heating was carried out on a hot plate at 100°C for 120 seconds for prebaking treatment, thereby forming a photosensitive transparent resin film having a thickness of 2µm as a transparent resin film A11. As the above positive photoresist, use was made of a positive photoresist containing an alkali-soluble alicyclic olefin-based resin described in JP-A-2002-296780. As an organic material forming the transparent resin film A11, use can be made of a transparent resin selected from the group consisting of an acrylic-based resin, a silicone-based resin, a fluorine-based resin, a polyimide-based resin, a polyolefin-based resin, an alicyclic olefin-based resin, and an epoxy-based resin. In terms of facilitating subsequent processes, the transparent resin film A11 is preferably formed using, particularly, a photosensitive transparent resin composition as described in detail in JP-A-2001-188343 or JP-A-2002-296780.

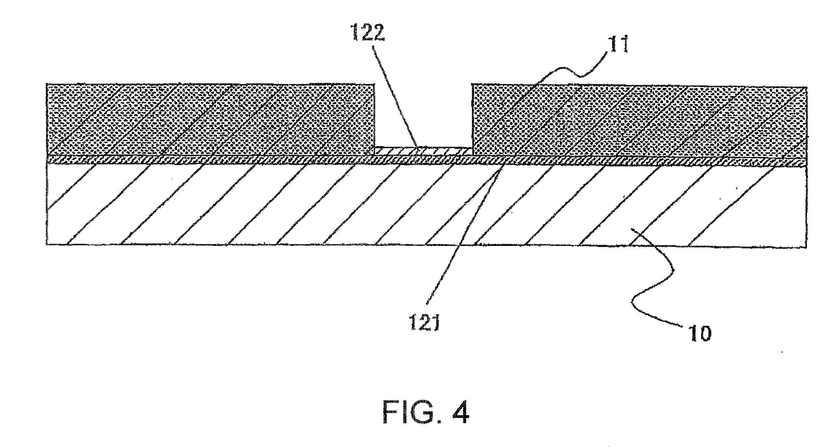

Referring to Fig. 4, after forming the photosensitive transparent resin film as the transparent resin film A11, mixed light of g, h, and i lines was selectively irradiated onto the photosensitive transparent resin film through a mask pattern by the use of a mask aligner. Then, after performing development for 90 seconds using a 0.3wt% tetramethylammonium hydroxide aqueous solution, rinsing was carried out for 60 seconds using pure water, thereby forming a groove having a predetermined pattern on the glass substrate 10. Thereafter, heat treatment was carried out in a nitrogen atmosphere at 230°C for 60 minutes to thereby cure the photosensitive transparent resin film (i.e. the transparent resin film A) 11.

Then, this was immersed in a palladium chloride-hydrochloric acid aqueous solution (palladium chloride 0.005vol%, hydrochloric acid 0.01vol%) at room temperature for 3 minutes, treated with a reducing agent (Reducer MAB-2 manufactured by C. Uyemura & Co., Ltd.), and washed with water, thereby selectively providing a palladium catalyst layer (thickness 10 to 50nm) 122 in the formed groove.

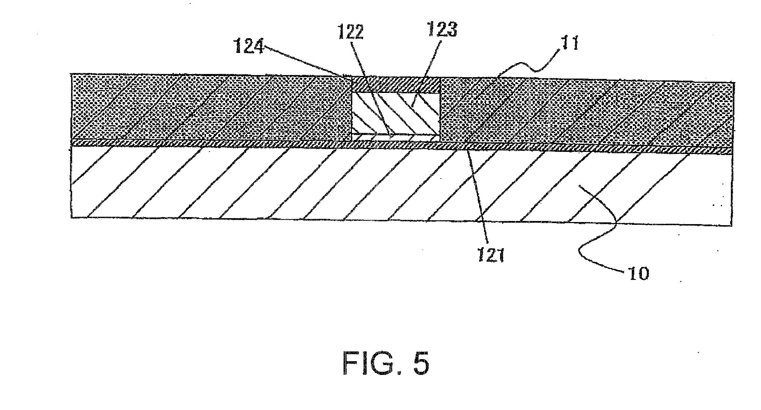

Referring to Fig. 5, the substrate provided with the palladium catalyst layer 122 was immersed in an electroless copper plating solution (PGT manufactured by C. Uyemura & Co., Ltd.), thereby selectively forming a copper layer (thickness 1.9µm) as a conductive metal layer 123 in the above groove.
It is preferable that the process be finished at a position where the copper layer is lower than the surface height of the transparent photosensitive resin 11 by the thickness of a subsequent conductive-metal diffusion suppressing film 124. Then, the substrate thus obtained was immersed in an electroless nickel plating solution, thereby forming the conductive-metal diffusion suppressing film 124 (thickness 0.1 µm) made of nickel on the copper layer as the conductive metal layer 123.

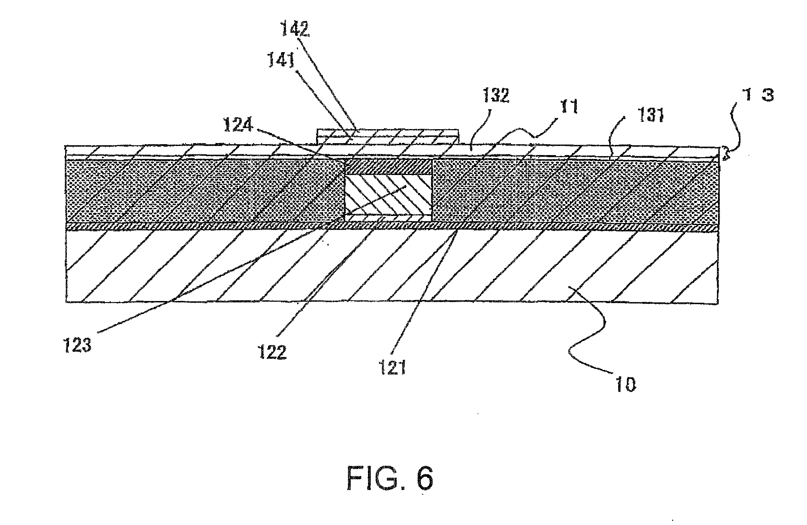

Then, referring to Fig. 6, an insulator coating film (i.e. a transparent insulator film B) 131 was formed so as to extend over the surface the transparent resin film 11, including the surface of the gate electrode 12.

The illustrated insulator coating film 131 was formed using the following coating agent. That is, methyltrimethoxysilane (71.0g), tetraethoxysilane (52.0g), IPA (isopropyl alcohol; 97.1g), 0.1N nitric acid (9.6g), and water (82.7g) were mixed in this order and then subjected to a hydrolysis-condensation reaction for 24 hours. A reacted solution thus obtained was diluted with a mixed solvent of methyl isobutyl ketone (437.0g) and propylene glycol monomethylether (250.5g), thereby obtaining a coating agent. This coating agent was coated and an obtained coating film was heat-treated at 300°C for 1 hour, thereby obtaining the insulator coating film 131.

The illustrated insulator coating film 131 was composed of a complex of polymethylsilsesquioxane (i.e. CH₃SiO_{1.5}) and silica (SiO₂) and had a thickness of 60nm. The relative permittivity was measured to be ε=2.5. Therefore, d/ε was 240. As a result of evaluating the transparency, Hz was 0.09% and Tt was 92.61%. Further, the surface roughness was measured by an AFM and Ra=4.5nm.

Then, a Si₃N₄ film was grown by CVD using a microwave-excited RLSA plasma processing apparatus to form an insulator film C132, thereby forming a gate insulating film 13 comprising the transparent insulator film B131 and the insulator film C132.

Herein, taking into account that the relative permittivity of a SiO₂ film having normally been used as a gate insulating film in the semiconductor industry is 3.9, the relative permittivity of the insulator film C132 is preferably 4 or more and more preferably 7 or more. The upper limit of the relative permittivity is normally about 7.5. Further, the insulator film C is preferably substantially transparent. There is no particular limitation to a material of the insulator film C that can satisfy those properties, but normally, a Si₃N₄ film is suitably used.

Then, as shown in Fig. 6, an amorphous silicon film 141 and an n+ amorphous silicon film 142 were continuously deposited by a known PECVD method and then the amorphous silicon films were partly removed except at a portion over the gate electrode 12 and its peripheral portion by a photolithography method and a known RIE method.

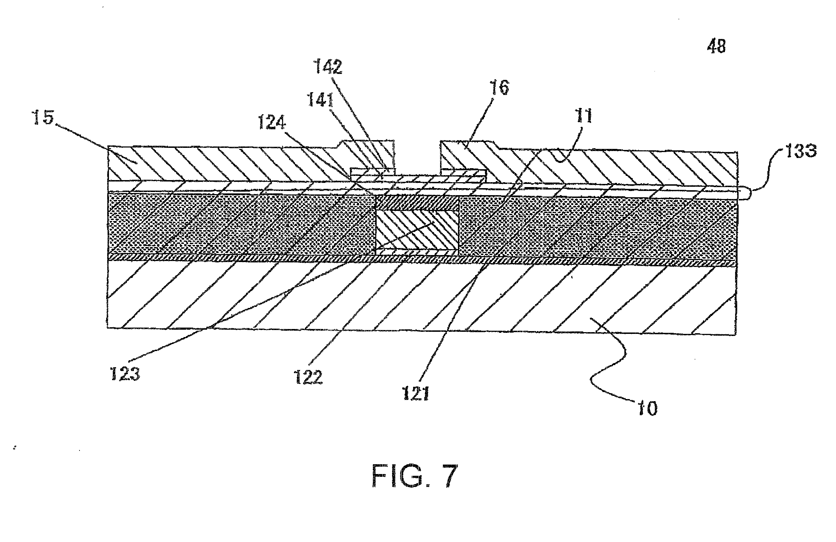

Referring to Fig. 7, subsequently, film formation was carried out in order of Ti, Al, and Ti by a known sputtering method or the like for obtaining a source electrode and a drain electrode and then patterning was performed by the photolithography method, thereby forming a source electrode 15 and a drain electrode 16. Then, using the formed source electrode 15 and drain electrode 16 as a mask, the n+ amorphous silicon film 142 was etched by a known technique, thereby separating a source region and a drain region. Then, a silicon nitride film (not illustrated) was formed as a protective film by the known PECVD method, thereby completing a thin-film transistor (TFT) of this invention. It is needless to say that the source electrode 15 and the drain electrode 16 form source wiring and drain wiring in regions other than the element region.

In the above embodiment, the description has been made only about the liquid crystal display device. However, this invention is applicable to various substrates forming flat display panels.

Further, the material forming the gate electrode may be silver or a transparent oxide conductor (ITO or the like) instead of copper.

### Industrial Applicability

This invention is applied to display devices such as a liquid crystal display device, an organic EL device, and an inorganic EL device and capable of increasing the size of those display devices, and is also applicable to wiring of other than the display devices.

## Claims

1. A semiconductor device comprising a transparent base, a transparent insulator film A provided on a main surface of said transparent base and formed with a groove reaching said main surface, a gate electrode formed in said groove so that a surface of said gate electrode and a surface of said transparent insulator film A are substantially flush with each other, and a semiconductor layer provided over said gate electrode through a gate insulating film, wherein said gate insulating film comprises at least two layers and wherein at least one layer of said gate insulating film is a transparent insulator film B which has a main skeleton of repeating MO units and which has a composition comprising one kind or two or more kinds of oxides each represented by RₓMO_{y} [where R represents a non-hydrolyzable substituent, M represents one element selected from a group consisting of Si, Ti, Al, Zr, Zn, Sn, and In, x represents an integer of 0 to 3, and y satisfies the following formula: (m-x)/2<y<m-x-0.5 (m represents a valence of M)].

2. A semiconductor device comprising a transparent base, a transparent insulator film A provided on a main surface of said transparent base and formed with a groove reaching said main surface, a gate electrode formed in said groove so that a surface of said gate electrode and a surface of said transparent insulator film A are substantially flush with each other, and a semiconductor layer provided over said gate electrode through a gate insulating film, wherein said gate insulating film comprises at least two layers and wherein at least one layer of said gate insulating film is a transparent insulator film B formed by heating in a temperature range of 150 to 300°C and having a turbidity (Hz) of 3% or less and a transmittance (Tt) of 80% or more.

3. A semiconductor device according to claim 1 or 2, wherein said transparent insulator film B is a transparent insulator coating film formed by coating a coating solution.

4. A semiconductor device according to any of claims 1 to 3, wherein said transparent insulator film B has a surface roughness (Ra) of 5nm or less.

5. A semiconductor device according to any of claims 1 to 4, wherein said transparent insulator film B satisfies a relationship of 280>d/ε where a thickness thereof is given by d(Å) and a relative permittivity thereof is given by ε.

6. A coating agent for forming the transparent insulator film B according to any of claims 3 to 5, further comprising one kind or a mixture of two or more kinds of mixed solutions each obtained by dissolving or dispersing, in an organic solvent, water, or a mixed solvent thereof, a condensate obtained by a hydrolysis-condensation reaction of a compound represented by RₓMXₘ₋ₓ (where R represents a non-hydrolyzable substituent, M represents one element selected from a group consisting of Si, Ti, Al, Zr. Zn, Sn, and In, X represents a hydrolyzable substituent, x represents an integer of 0 to 3, and m represents a valence of M).

7. A coating agent for forming the transparent insulator film B according to any of claims 3 to 5, formed by dissolving or dispersing, in an organic solvent, water, or a mixed solvent thereof, a condensate obtained by a hydrolysis-condensation reaction of one kind or two or more kinds of compounds each represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents a valence of M).

8. A coating agent according to claim 6 or 7, wherein said hydrolyzable substituent X is an alkoxyl group.

9. A semiconductor device according to any of claims 1 to 5, wherein said gate insulating film further comprises an insulator film C formed by CVD and having a relative permittivity of 4 or more.

10. A semiconductor device according to claim 9, wherein said insulator film C is transparent and extends over said transparent insulator film B.

11. A semiconductor device manufacturing method, comprising
forming a transparent insulator film A on a surface of a transparent base,
forming a groove, reaching said transparent base, by selectively removing part of said transparent insulator film A,
forming, in said groove, a gate electrode reaching the surface of said transparent base,
coating, on a surface of said transparent insulator film A including a surface of said gate electrode, either a coating agent which comprises one kind or a mixture of two or more kinds of mixed solutions each obtained by dissolving or dispersing, in an organic solvent, water, or a mixed solvent thereof, a condensate obtained by a hydrolysis-condensation reaction of a compound represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents a valence of M) or a coating agent which is obtained by dissolving or dispersing, in an organic solvent, water, or a mixed solvent thereof, a condensate obtained by a hydrolysis-condensation reaction of one kind or two or more kinds of compounds each represented by RₓMXₘ₋ₓ (where R represents a non-hydrolyzable substituent, M represents one element selected from a group consisting of Si, Ti, Al, Zr, Zn, Sn, and In, X represents a hydrolyzable substituent, x represents an integer of 0 to 3, and m represents a valence of M),
heating a coating film obtained in said coating, and
forming a semiconductor film over a transparent insulator film B thus obtained.

12. A semiconductor device manufacturing method according to claim 11, wherein said hydrolyzable substituent X is an alkoxyl group.

13. A semiconductor device manufacturing method according to claim 11 or 12, further comprising, between said coating film heating and said semiconductor film forming, forming a transparent insulator film C having a relative permittivity of 4 or more by CVD so as to cover said transparent insulator film B.
